# FASCICULE DE BREVET EUROPEEN

(11) **EP 4 511 884 B1**
(45) Date de publication et mention de la délivrance du brevet: **18.02.2026**
(21) Numéro de dépôt: 23716351.4
(22) Date de dépôt: 22.03.2023
(51) Int. Cl.: H10F 19/80, H10F 19/85

(54) **MODULE PHOTOVOLTAÏQUE LÉGER ET RÉSISTANT AUX CHOCS**
LEICHTES, SCHLAGFESTES PHOTOVOLTAISCHES MODUL
LIGHTWEIGHT, IMPACT-RESISTANT PHOTOVOLTAIC MODULE

(30) Priorité: 20.04.2022 FR 2203624
(43) Date de publication de la demande: 26.02.2025
(73) Titulaire: Commissariat à l'Energie Atomique et aux Energies Alternatives, 75015 Paris (FR)
(72) Inventeur: GAUME, Julien, 38054 GRENOBLE CEDEX 09 (FR); COMMAULT, Benjamin, 38054 GRENOBLE CEDEX 09 (FR); PLANELLS VALENCIA, Maria, 38054 GRENOBLE CEDEX 09 (FR); VESCHETTI, Yannick, 38054 GRENOBLE CEDEX 09 (FR)
(74) Mandataire: Regimbeau
(86) Numéro de dépôt international: PCT/FR2023/050412
(87) Numéro de publication internationale: WO 2023/203289

(56) Documents cités:
- JP-A- 2013 038 321
- JP-A- 2021 016 278
- US-A1- 2011 226 312
- US-A1- 2014 299 180
- US-A1- 2017 338 363

## Description

### Domaine technique

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en œuvre pour de nombreuses applications, notamment civiles et/ou militaires, par exemple des applications autonomes et/ou embarquées, étant particulièrement concernée par les applications qui requièrent l'utilisation de modules photovoltaïques légers, en particulier d'un poids par unité de surface inférieur à 5 kg/m², voire 6 kg/m², notamment destinés à être fixés sur un support rigide et résistant aux chocs de type grêle selon la norme IEC 61215. Elle peut ainsi notamment être appliquée pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades (mobilité solaire), en particulier pour une intégration sur des véhicules, tels que voitures, bus ou bateaux, entre autres.

L'invention propose ainsi un module photovoltaïque léger obtenu par un empilement comportant une première couche en verre et polymère formant la face avant du module, ainsi qu'un procédé de réalisation d'un tel module photovoltaïque.

### Technique antérieure

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, notamment du verre trempé, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 300 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type IBC (pour « Interdigitated Back Contact » en anglais).

Il est à noter que les cellules photovoltaïques de type IBC (« Interdigitated Back Contact ») sont des structures pour lesquelles les contacts sont réalisés sur la face arrière de la cellule en forme de peignes interdigités. Elles sont par exemple décrites dans le brevet américain US 4,478,879 A.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

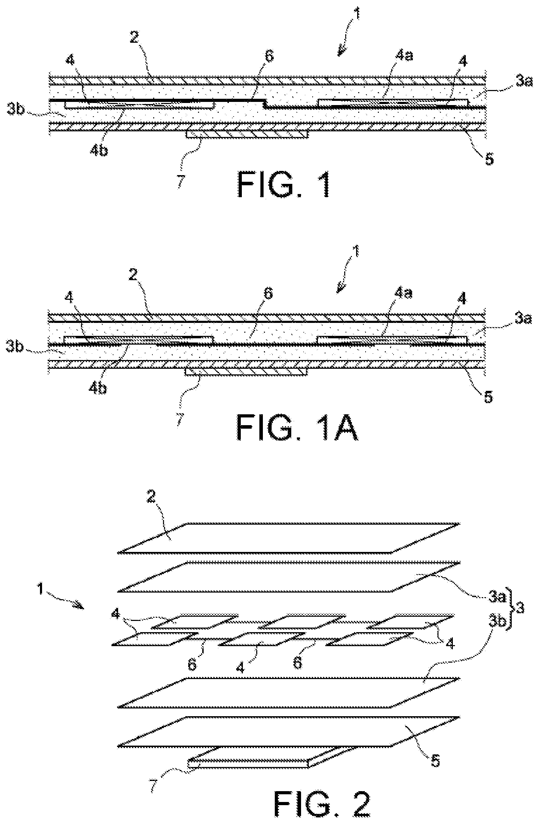

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

La figure 1A représente en outre une variante de réalisation de l'exemple de la figure 1 dans laquelle les cellules photovoltaïques 4 sont de type IBC, les conducteurs de liaison 6 étant uniquement disposés contre les faces arrières des cellules photovoltaïques 4.

Par ailleurs, les figures 1 et 2 représentent également la boîte de jonction 7 du module photovoltaïque 1, destinée à recevoir le câblage nécessaire à l'exploitation du module. Classiquement, cette boîte de jonction 7 est réalisée en plastique ou en caoutchouc, et présente une étanchéité complète.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 165°C, et pendant une durée du cycle de lamination généralement d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche avant de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard qui possède une résistance mécanique importante grâce à l'utilisation d'une face avant 2 en verre épais et du cadre aluminium, lui permettant, notamment et dans la majorité des cas, de respecter les normes IEC 61215 et IEC 61730.

Néanmoins, un tel module photovoltaïque 1 selon la conception classique de l'art antérieur présente l'inconvénient d'avoir un poids relativement élevé, en particulier un poids par unité de surface d'environ 10 à 12 kg/m², et n'est ainsi pas adapté pour certaines applications pour lesquelles la légèreté est une priorité.

Ce poids élevé du module photovoltaïque 1 provient principalement de la présence du verre épais, avec une épaisseur d'environ 3 mm, pour former la face avant 2, la densité du verre étant en effet élevée, de l'ordre de 2,5 kg/m²/mm d'épaisseur, et du cadre aluminium. Pour pouvoir résister aux contraintes lors de la fabrication, avoir une meilleure résistance mécanique aux impacts et également pour des raisons de sécurité, par exemple du fait du risque de coupure, le verre est trempé. Or, l'infrastructure industrielle de la trempe thermique est configurée pour traiter du verre d'au moins 2 mm d'épaisseur et des difficultés techniques existent également. En outre, le choix d'avoir une épaisseur de verre d'environ 3 mm est également lié à une résistance mécanique à la pression normée de 5,4 kPa. En définitif, le verre représente ainsi à lui seul pratiquement 70 % du poids du module photovoltaïque 1, et plus de 80 % avec le cadre en aluminium autour du module photovoltaïque 1.

Aussi, afin d'obtenir une réduction significative du poids d'un module photovoltaïque pour permettre son utilisation dans des applications exigeantes en termes de légèreté, par exemple les toitures commerciales lorsque la structure du bâtiment n'est pas prévue pour une surcharge liée au photovoltaïque, il existe un besoin pour trouver une solution alternative à l'utilisation d'un verre épais en face avant du module.

Une des possibilités consiste à remplacer la face avant en verre par des matériaux plastiques tout en conservant l'architecture et la méthode de mise en œuvre habituelles avec pour but premier la diminution importante du poids surfacique. Ainsi, des feuilles de polymères, comme le polycarbonate (PC), le polytéréphtalate d'éthylène (PET), le polyméthacrylate de méthyle (PMMA), le polyfluorure de vinylidène (PVDF), l'éthylène tétrafluoroéthylène (ETFE), l'éthylène chlorotrifluoroéthylène (ECTFE), ou l'éthylène propylène fluoré (FEP), peuvent représenter une alternative au verre. Cependant, lorsque seul le remplacement du verre par une telle feuille de polymères est envisagé, en fonction de l'épaisseur choisie, la cellule photovoltaïque devient très vulnérable au choc, à la charge mécanique et aux dilatations différentielles.

Une alternative est l'utilisation de matériaux composites, notamment des renforts, par exemple de type fibres de verre, fibres de carbone ou fibres naturelles telles que lin, chanvre, entre autres, qui viennent en complément de l'encapsulant standard pour former un composite de type polymère/fibres associé à un film de protection polymère en face avant. Le gain de poids peut être significativement important en dépit d'une moins bonne transparence et d'une incertitude sur les aspects de performance sur des durées supérieures à 20 ans.

La suppression du verre en face avant des modules photovoltaïques a fait l'objet de plusieurs brevets ou demandes de brevet dans l'art antérieur. On peut ainsi citer à ce titre la demande de brevet FR 2 955 051 A1, la demande de brevet américain US 2005/0178428 A1 ou encore les demandes internationales WO 2008/019229 A2 et WO 2012/140585 A1. D'autres brevets ou demandes de brevet ont décrit l'utilisation de renforts seuls ou en composites, comme par exemple la demande de brevet européen EP 2 863 443 A1, ou encore les demandes internationales WO 2018/076525 A1, WO 2019/006764 A1 et WO 2019/006765 A1, ou encore la demande japonaise JP 2013 038321 A.

### Exposé de l'invention

Il existe ainsi un besoin pour concevoir une solution alternative de module photovoltaïque prévu pour être léger afin de s'adapter à certaines applications, tout en présentant des propriétés mécaniques suffisantes lui permettant d'être résistant aux chocs et à la charge mécanique, et en particulier aux normes IEC 61215 et IEC 61730.

L'invention, telle que définie dans les revendications 1 et 15, a donc pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque obtenu à partir d'un empilement comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques, obtenu par la réunion d'une couche avant de matériau d'encapsulation et d'une couche arrière de matériau d'encapsulation de part et d'autre des cellules photovoltaïques, avantageusement en contact direct avec celles-ci, la couche avant de matériau d'encapsulation étant située entre la première couche et les cellules photovoltaïques,
- une deuxième couche formant la face arrière du module photovoltaïque, l'ensemble encapsulant et la pluralité de cellules photovoltaïques étant situés entre les première et deuxième couches,

caractérisé en ce que la première couche comporte :
   - une couche avant réalisée en au moins un matériau polymère, dite « couche avant polymère », et
   - au moins un ensemble avant comprenant une couche avant d'interface et une couche avant en verre, la couche avant en verre présentant une épaisseur inférieure ou égale à 2 mm,
ledit au moins un ensemble avant étant situé entre la couche avant polymère et l'ensemble encapsulant, et la couche avant d'interface dudit au moins un ensemble avant étant située entre la couche avant polymère et la couche avant en verre,
en ce que la couche avant de matériau d'encapsulation est formée par au moins une couche comportant au moins un matériau d'encapsulation de type polymère ayant un module de Young à 25°C compris entre 2 et 20 MPa, et en ce que la couche arrière de matériau d'encapsulation est formée par au moins une couche comportant au moins un matériau d'encapsulation de type polymère ayant un module de Young à 25°C strictement supérieur à 200 MPa.

De façon avantageuse, l'invention permet le remplacement du verre épais standard d'épaisseur d'environ 3 mm, habituellement utilisé en face avant dans un module photovoltaïque classique, par une combinaison de couche(s) polymère(s) et de couche(s) mince(s) en verre. Ainsi, l'utilisation de verre(s) mince(s) et de polymère(s) permet d'obtenir une faible masse et une transparence équivalente à un module standard. Si l'on compare l'invention aux modules légers disponibles commercialement, la présence de verre mince dans la structure permet une meilleure résistance aux chocs et aux dilatations thermomécaniques par rapport aux modules légers avec films polymères transparents en face avant, et également à la pénétration d'humidité.

Avantageusement encore, l'utilisation de matériau d'encapsulation de type polymère avec des propriétés mécaniques renforcées, notamment pour la couche arrière de matériau d'encapsulation de l'ensemble encapsulant, peut permettre d'améliorer encore la résistance aux chocs, notamment de type grêle, sur le module photovoltaïque, et de protéger les cellules photovoltaïques d'éventuels endommagements mécaniques.

Le terme « transparent » signifie que la première couche formant la face avant du module photovoltaïque est au moins partiellement transparente à la lumière visible, laissant passer au moins environ 80 % de cette lumière.

En particulier, la transparence optique, entre 300 et 1200 nm, de la première couche formant la face avant du module photovoltaïque, notamment la couche avant polymère, peut être supérieure à 80 %. De même, la transparence optique, entre 300 et 1200 nm, de l'ensemble encapsulant peut être supérieure à 90 %, tout comme celle de la couche avant d'interface.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau(x) d'encapsulation, réunies entre elles après lamination pour former l'ensemble encapsulant.

En effet, initialement, c'est-à-dire avant toute opération de lamination, l'ensemble encapsulant est constitué par au moins deux couches de matériau(x) d'encapsulation, dites couches de cœur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Par ailleurs, grâce à l'invention, il peut être possible d'obtenir un nouveau type de module photovoltaïque léger qui, par l'utilisation de verre mince, peut présenter un poids surfacique inférieur à 6 kg/m², voire 5 kg/m², tout en conservant la transparence optique de la face avant et en assurant une bonne fiabilité du module photovoltaïque avec une faible dilatation thermomécanique et une haute durabilité. De plus, l'utilisation de la couche avant polymère et de couche(s) d'interface permet de protéger le verre mince des chocs, notamment de type grêlons.

Le module photovoltaïque selon l'invention peut en outre comporter l'une ou plusieurs des caractéristiques suivantes prises isolément ou suivant toutes combinaisons techniques possibles.

La couche avant de matériau d'encapsulation est formée par au moins une couche comportant au moins un matériau d'encapsulation de type polymère ayant un module de Young à 25°C compris entre 2 et 20 MPa, notamment compris entre 10 et 20 MPa.

De plus, la couche arrière de matériau d'encapsulation est formée par au moins une couche comportant au moins un matériau d'encapsulation de type polymère ayant un module de Young à 25°C strictement supérieur à 200 MPa, notamment strictement supérieur à 200 MPa et inférieur à 500 MPa, notamment compris entre 250 et 350 MPa.

Par ailleurs, l'élongation à rupture de la couche avant de matériau d'encapsulation et/ou de la couche arrière de matériau d'encapsulation peut avantageusement être au minimum supérieure à 200 %.

L'utilisation d'une couche arrière de matériau d'encapsulation avec un module de Young élevé, peut permettre d'obtenir une résistance accrue aux chocs de type grêlons.

La couche avant en verre peut avantageusement présenter une épaisseur inférieure ou égale à 1,5 mm, préférentiellement comprise entre 500 µm et 1 mm.

Par ailleurs, la couche avant en verre peut avantageusement être réalisée en verre non trempé. Autrement dit, le verre ne subit aucune trempe thermique ou chimique. En effet, le verre non trempé peut être moins résistant aux chocs, notamment ceux liés aux impacts de grêlons. Cependant, étant placé entre des couches protectrices polymères, le verre non trempé peut être protégé des chocs. Le verre non trempé peut également permettre d'assurer une barrière de protection à l'humidité pour les cellules photovoltaïques. L'utilisation de verre non trempé, plutôt que du verre trempé, peut permettre de réduire considérablement les coûts de sorte à rendre le module photovoltaïque adaptable à de nombreuses applications.

De plus, la deuxième couche peut être réalisée en au moins un matériau polymère, notamment choisi parmi : le polycarbonate (PC), le polyméthacrylate de méthyle (PMMA), le polytéréphtalate d'éthylène (PET), le polypropylène (PP), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités, entre autres. Le choix d'une deuxième couche réalisée en au moins un matériau polymère peut être privilégié dans le cas où l'application finale du module photovoltaïque nécessite une surimposition de celui-ci sur un support rigide.

En variante, du fait de la suppression du verre épais en face avant du module photovoltaïque classique et du cadre en aluminium qui peut induire une perte de tenue mécanique du module, et pour pouvoir conserver un module rigide, la face arrière du module peut être prévue pour présenter une rigidité mécanique suffisante.

En particulier, selon une première possibilité, la deuxième couche peut ainsi comporter :
- une couche arrière formant un panneau arrière en matériau composite, comprenant une sous-couche principale, formant l'âme du panneau arrière, et deux sous-couches de recouvrement, formant chacune une plaque du panneau arrière, disposées de part et d'autre de l'âme de sorte que l'âme soit prise en sandwich entre les deux plaques, l'âme du panneau arrière comportant une structure alvéolaire.

L'âme du panneau arrière peut comporter une structure alvéolaire, par exemple sous forme de nid d'abeilles, notamment réalisée en métal, par exemple aluminium, en polyimide, en polycarbonate (PC), en polypropylène (PP) ou en fibres synthétiques hautes performances, par exemple de type Nomex^{®}.

En variante, l'âme du panneau arrière peut comporter une structure alvéolaire sous forme de mousse, notamment réalisée en polytéréphtalate d'éthylène (PET), en polychlorure de vinyle (PVC) ou en polyuréthane (PU).

En outre, les plaques du panneau arrière peuvent être réalisées en matériau composite, par exemple de type prépreg fibres de verre/époxy, en métal, notamment en aluminium, en polycarbonate (PC), en polyméthacrylate de méthyle (PMMA) ou à partir de pré-imprégnés.

Les plaques du panneau arrière peuvent, le cas échéant, être recouvertes d'un film mono ou multicouche polymère, par exemple du type Tedlar^{®}.

De plus, le panneau arrière peut présenter un poids surfacique inférieur ou égal à 3 kg/m², notamment inférieur ou égal à 2 kg/m², notamment encore inférieur ou égal à 1 kg/m².

Il est à noter que, plutôt que d'avoir une face arrière de type panneau sandwich, la deuxième couche peut encore comporter une couche arrière comportant une structure alvéolaire, sans l'utilisation de sous-couches de recouvrement, par exemple une structure alvéolaire de type polycarbonate alvéolaire.

Selon une deuxième possibilité, la deuxième couche peut comporter :
- une couche arrière réalisée en au moins un matériau polymère, dite « couche arrière polymère », et
- au moins un ensemble arrière comprenant une couche arrière d'interface et une couche arrière en verre, la couche arrière en verre présentant notamment une épaisseur inférieure ou égale à 2 mm, préférentiellement encore inférieure ou égale à 1,5 mm, notamment comprise entre 500 µm et 1 mm, et étant notamment réalisée en verre non trempé,
ledit au moins un ensemble arrière étant situé entre la couche arrière polymère et l'ensemble encapsulant, et la couche arrière d'interface dudit au moins un ensemble arrière étant située entre la couche arrière polymère et la couche arrière en verre.

Ainsi, la deuxième couche peut être obtenue selon un principe analogue à celui utilisé pour la première couche. En particulier, la deuxième couche peut également comporter une combinaison de verre(s) mince(s) et de polymère(s). La deuxième couche peut être ou non identique à la première couche.

Selon une troisième possibilité, la deuxième couche peut comporter une couche de renforts à base de fibres.

Par « couche de renforts à base de fibres », on entend une couche comportant majoritairement des fibres organiques et/ou inorganiques, et de préférence une couche constituée de fibres organiques et/ou inorganiques. Avantageusement, une couche de renforts à base de fibres permet un renfort mécanique à l'empilement de couches destinées à former le module photovoltaïque. Avant lamination, les fibres d'une couche de renforts à base de fibres sont préférentiellement non imprégnées, notamment par un matériau polymère. Une telle couche de renforts peut être dite fibrée ou tissée. En particulier, une telle couche de renforts n'est pas une couche de pré-imprégné, ni une couche composite.

La couche de renforts à base de fibres peut comporter des fibres tissées ou non tissées. Elle peut en outre présenter un poids surfacique compris entre 20 g/m² et 1500 g/m², et de préférence entre 300 g/m² et 800 g/m², Elle peut comporter des fibres de verre, de carbone, d'aramide et/ou des fibres naturelles, notamment de chanvre, de lin et/ou de soie, entre autres.

Le verre utilisé pour la couche avant en verre et/ou la couche arrière en verre peut notamment être du verre sodo-calcique, à base de silice, de calcium et de sodium.

Par ailleurs, la couche avant polymère et/ou la couche arrière polymère peuvent présenter une épaisseur comprise entre 15 µm et 300 µm, notamment entre 20 µm et 50 µm.

De plus, le matériau polymère de la couche avant polymère et/ou de la couche arrière polymère peut être choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités, entre autres.

En outre, la couche avant polymère et/ou la couche arrière polymère peuvent présenter un filtre de coupure UV (« UV cutoff » en anglais) compris entre 320 nm et 450 nm, ce qui correspond à la longueur d'onde pour laquelle le taux de transmission est égale à 50%. De cette façon, les couches sous-jacentes peuvent être protégées du vieillissement aux rayonnements ultraviolets (UV) et éventuellement de l'hydrolyse, ce qui procure au module photovoltaïque une durée de vie allongée.

La couche avant d'interface et/ou la couche arrière d'interface peuvent permettre le collage entre la couche avant polymère, respectivement la couche arrière polymère, et une couche en verre, ou entre deux couches en verre.

La couche avant d'interface et/ou la couche arrière d'interface peuvent présenter une épaisseur comprise entre 50 µm et 600 µm, préférentiellement entre 400 µm et 600 µm, voire encore entre 400 µm et 500 µm.

La couche avant d'interface et/ou la couche arrière d'interface peuvent présenter un module de Young compris entre 2 et 300 MPa à 25°C, préférentiellement entre 2 et 250 MPa à 25°C, voire encore entre 10 et 50 MPa à 25°C, voire encore entre 2 et 50 MPa à 25°C, voire encore entre 2 et 20 MPa à 25°C.

En outre, la couche avant d'interface et/ou l'éventuelle couche arrière d'interface peuvent être formés par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée, entre autres.

La couche avant de matériau d'encapsulation peut être formée par au moins une couche comportant au moins un matériau d'encapsulation de type polymère choisi parmi : le poly(éthylène-acétate de vinyle) (EVA), les acétals de vinyle, tels que les polyvinylbutyrals (PVB), les polyuréthanes, les élastomères de silicone, les élastomères à base de polyoléfine thermoplastique réticulée et/ou les élastomères à base de polyoléfine thermoplastique réticulée (TPO), entre autres.

La couche arrière de matériau d'encapsulation peut être formée par au moins une couche comportant au moins un matériau d'encapsulation de type polymère choisi parmi : les copolymères d'acides, les ionomères, les chlorures de polyvinyle et/ou les polyéthylènes, entre autres.

De façon préférentielle, le matériau d'encapsulation, et/ou l'épaisseur du matériau d'encapsulation, de l'ensemble encapsulant, notamment de la couche avant de matériau d'encapsulation, est identique au matériau, et/ou l'épaisseur du matériau, de la couche avant d'interface, et de l'éventuelle couche arrière d'interface. De cette façon, il peut être possible de faciliter le procédé de fabrication.

La couche avant de matériau d'encapsulation et/ou la couche arrière de matériau d'encapsulation de l'ensemble encapsulant peuvent présenter une épaisseur comprise entre 200 µm et 600 µm, notamment entre 400 µm et 600 µm.

De plus, les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques de type IBC, et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS), le cuivre-indium/gallium diséléniure (CIGS), et les perovskites, entre autres.

Par ailleurs, les cellules photovoltaïques peuvent présenter une épaisseur comprise entre 1 et 300 µm, notamment entre 1 et 200 µm, et avantageusement entre 70 µm et 160 µm.

Le module photovoltaïque peut en outre comporter une ou plusieurs boîtes de jonction, destinées à recevoir le câblage nécessaire à l'exploitation du module photovoltaïque, pouvant être positionnées en face avant ou en face arrière du module, préférentiellement en face avant.

En outre, l'espacement entre deux cellules photovoltaïques voisines, ou encore consécutives ou adjacentes, peut dans certaines configurations être supérieur ou égal à 1 mm, notamment compris entre 1 mm et 30 mm, et de préférence égal à 2 mm. Dans d'autres configurations, notamment de type « shingle » selon l'appellation anglaise (ou « bardeau » en français), les cellules photovoltaïques voisines, ou encore consécutives ou adjacentes, peuvent se chevaucher.

Selon un mode de réalisation particulier, la première couche peut comporter :
- un premier ensemble avant comprenant une couche avant d'interface et une couche avant en verre, la couche avant en verre présentant une épaisseur inférieure ou égale à 2 mm,
- un deuxième ensemble avant comprenant une couche avant d'interface et une couche avant en verre, la couche avant en verre présentant une épaisseur inférieure ou égale à 2 mm,
le premier ensemble avant étant situé entre la couche avant polymère et le deuxième ensemble avant, lui-même situé entre le premier ensemble avant et l'ensemble encapsulant.

L'épaisseur de la couche avant en verre du premier ensemble avant et l'épaisseur de la couche avant en verre du deuxième ensemble avant peuvent être identiques ou différentes. En particulier, l'épaisseur de la couche avant en verre du premier ensemble avant peut être supérieure à l'épaisseur de la couche avant en verre du deuxième ensemble avant.

En outre, la deuxième couche peut comporter :
- une couche arrière réalisée en au moins un matériau polymère, dite « couche arrière polymère », et
- un premier ensemble arrière comprenant une couche arrière d'interface et une couche arrière en verre, la couche arrière en verre présentant notamment une épaisseur inférieure ou égale à 2 mm, notamment inférieure ou égale à 1,5 mm, notamment comprise entre 500 µm et 1 mm, et étant notamment réalisée en verre non trempé,
- un deuxième ensemble arrière comprenant une couche arrière d'interface et une couche arrière en verre, la couche arrière en verre présentant notamment une épaisseur inférieure ou égale à 2 mm, notamment inférieure ou égale à 1,5 mm, notamment comprise entre 500 µm et 1 mm, et étant notamment réalisée en verre non trempé,
ledit premier ensemble arrière étant situé entre la couche arrière polymère et le deuxième ensemble arrière, lui-même situé entre le premier ensemble arrière et l'ensemble encapsulant.

De plus, l'invention a encore pour objet, selon un autre de ses aspects, un procédé de réalisation d'un module photovoltaïque, notamment tel que défini précédemment, à partir d'un empilement comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques, obtenu par la réunion d'une couche avant de matériau d'encapsulation et d'une couche arrière de matériau d'encapsulation de part et d'autre des cellules photovoltaïques, la couche avant de matériau d'encapsulation étant située entre la première couche et les cellules photovoltaïques,
- une deuxième couche, l'ensemble encapsulant et la pluralité de cellules photovoltaïques étant situés entre les première et deuxième couches,

caractérisé en ce que la première couche comporte :
   - une couche avant réalisée en au moins un matériau polymère, dite « couche avant polymère », et
   - au moins un ensemble avant comprenant une couche avant d'interface et une couche avant en verre, la couche avant en verre présentant une épaisseur inférieure ou égale à 2 mm,
ledit au moins un ensemble avant étant situé entre la couche avant polymère et l'ensemble encapsulant, et la couche avant d'interface dudit au moins un ensemble avant étant située entre la couche avant polymère et la couche avant en verre,
la couche avant de matériau d'encapsulation étant formée par au moins une couche comportant au moins un matériau d'encapsulation de type polymère ayant un module de Young à 25°C compris entre 2 et 20 MPa,
la couche arrière de matériau d'encapsulation étant formée par au moins une couche comportant au moins un matériau d'encapsulation de type polymère ayant un module de Young à 25°C strictement supérieur à 200 MPa,
et en ce que le procédé comporte l'étape de lamination à chaud et sous vide des couches constitutives de l'empilement pour obtenir le module photovoltaïque.

L'étape de lamination à chaud et sous vide peut en particulier être réalisée à une température supérieure ou égale à 120°C, voire 140°C, voire encore 150°C, et inférieure ou égale à 170°C, voire 180°C, typiquement comprise entre 130°C et 180°C, voire entre 145°C et 165°C, et pendant une durée du cycle de lamination d'au moins 5 minutes, voire 10 minutes, voire 15 minutes, notamment comprise entre 5 et 20 minutes.

Ainsi, il est possible d'obtenir une encapsulation totale du verre mince permettant de le protéger face aux chocs.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### Brève description des dessins

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 1A représente une variante de réalisation de l'exemple de la figure 1 dans laquelle les cellules photovoltaïques sont de type IBC,
- la figure 2 représente, en vue éclatée, le module photovoltaïque de la figure 1,
- la figure 3 illustre, en perspective et en vue éclatée, un premier exemple de réalisation d'un module photovoltaïque conforme à l'invention,
- la figure 3A illustre, en coupe, un exemple de couche arrière utilisée en variante pour le module photovoltaïque représenté à la figure 3,
- la figure 4 illustre, en perspective et en vue éclatée, un deuxième exemple de réalisation d'un module photovoltaïque conforme à l'invention,
- la figure 5 illustre, en perspective et en vue éclatée, un troisième exemple de réalisation d'un module photovoltaïque conforme à l'invention, et
- la figure 6 illustre, en perspective et en vue éclatée, un quatrième exemple de réalisation d'un module photovoltaïque conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### Exposé détaillé de l'invention

Les figures 1, 1A et 2 ont déjà été décrites dans la partie relative à l'état de la technique antérieure.

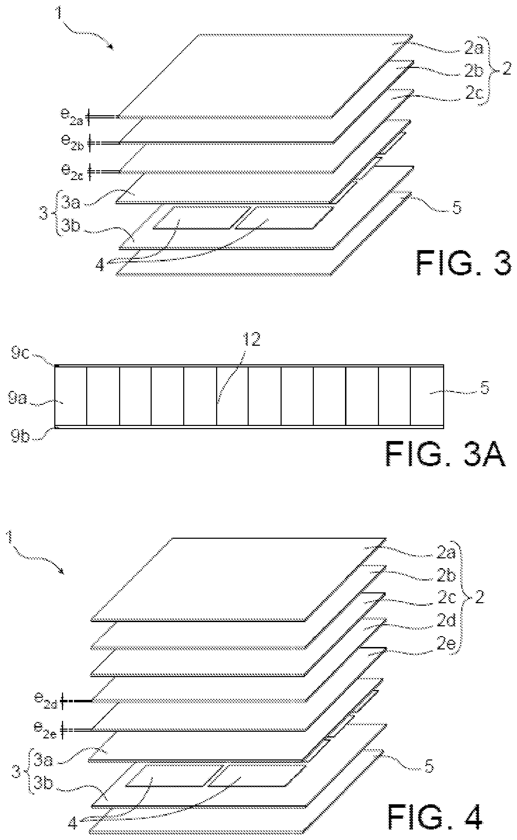

Les figures 3 à 6 permettent d'illustrer quatre modes de réalisation distincts de modules photovoltaïques 1 conformes à l'invention.

On considère ici que les cellules photovoltaïques 4, interconnectées par des rubans en cuivre étamé soudés, semblables à ceux représentés aux figures 1, 1A et 2, sont des cellules « cristallines », c'est-à-dire qu'elles comportent du silicium mono ou multicristallin, et qu'elles présentent une épaisseur comprise entre 1 et 250 µm.

De plus, la couche avant polymère 2a peut être un film polymère fluoré, d'épaisseur de l'ordre de 50 µm, notamment en éthylène tétrafluoroéthylène (ETFE), par exemple de type Saint-Gobain ChemFilm^{®} ETFE-E2.

Les couches d'interface 2b, 2d et 5b peuvent comporter un film encapsulant polymère, par exemple de type A formé par un élastomère thermoplastique à base polyoléfine (TPO) avec un module de Young à 25°C de 18 MPa ou de type B formé par un copolymère thermoplastique réticulé ioniquement, par exemple de type lonomère, avec un module de Young à 25°C de 285 MPa. L'épaisseur peut être comprise entre 500 et 600 µm, et être par exemple de l'ordre de 500 µm. En particulier, pour un film encapsulant polymère de type A, il peut s'agir du Borealis Quentys^{®} BPO8828UV, et pour un film encapsulant polymère de type B, il peut s'agir du KuranSeal-ES^{®} (PV8729D/UV CUT) de la société Kurabo, d'épaisseur 500 µm.

Les couches en verre 2c, 2e et 5c peuvent comporter un verre mince non trempé d'épaisseur comprise entre 500 et 1000 µm, par exemple de l'ordre de 950 µm.

La deuxième couche 5, lorsque réalisée sous la forme d'un multicouche polymère, peut intégrer une couche aluminisée.

La deuxième couche 5, lorsque sous forme de panneau arrière 5, peut comporter une âme 9a en nid d'abeilles en polypropylène et des peaux composites ou plaques 9b, 9c en polypropylène renforcées en verre avec une épaisseur comprise par exemple entre 6 et 10 mm, par exemple de type Nidapan^{®} 8 GR 600 d'épaisseur 10 mm.

Bien entendu, ces choix ne sont nullement limitatifs.

Pour tous les exemples d'empilement décrits en référence aux figures 3 à 6, des tests ont été effectués vis-à-vis de chocs mécaniques de type grêlons, de 25 mm de diamètre, pour des niveaux d'énergie de 2 J représentatifs de la norme de certification IEC 61215. Les tests de choc mécanique ont été réalisés en collant le module photovoltaïque 1 sur un support rigide représentatif de celui des toitures planes, terrasses, ou de bâtiments commerciaux.

Les résultats ont démontré l'amélioration accrue de la résistance aux chocs avec l'usage d'un encapsulant ayant des propriétés mécaniques renforcées au niveau de la couche arrière de matériau d'encapsulation de l'ensemble encapsulant.

Afin de décrire les différentes configurations envisagées, on se réfère tout d'abord à la figure 3 qui illustre, en perspective et en vue éclatée, un premier exemple de réalisation d'un module photovoltaïque 1 conforme à l'invention.

Il est à noter que la figure 3 correspond à une vue éclatée du module photovoltaïque 1 avant l'étape de lamination du procédé selon l'invention. Une fois l'étape de lamination réalisée, assurant un pressage à chaud et sous vide, les différentes couches sont en réalité au contact les unes aux autres, et notamment interpénétrées les unes dans les autres.

Le module photovoltaïque 1, ou plus précisément l'empilement destiné à former le module photovoltaïque 1, comporte ainsi une première couche 2 formant la face avant du module photovoltaïque 1 et destinée à recevoir un flux lumineux, une pluralité de cellules photovoltaïques 4 disposées côte à côte et reliées électriquement entre elles, un ensemble encapsulant 3 la pluralité de cellules photovoltaïques 4, comprenant une couche avant 3a de matériau d'encapsulation et une couche arrière 3b de matériau d'encapsulation situées de part et d'autres des cellules photovoltaïques 4, et une deuxième couche 5 formant la face arrière du module photovoltaïque 1.

Il est en outre à noter qu'une boîte de jonction 7 peut être disposée sur la face avant ou encore sur la face arrière, comme représenté sur les figures 1, 1A et 2, du module photovoltaïque 1.

Conformément à l'invention, et de manière commune aux exemples des figures 3 à 6, la première couche 2 comporte une couche avant réalisée en un matériau polymère 2a, dite « couche avant polymère 2a », et un premier ensemble avant 2b, 2c comprenant une couche avant d'interface 2b et une couche avant en verre, avantageusement en verre non trempé 2c.

Avantageusement, la couche avant en verre 2c présente une épaisseur e_{2c} inférieure ou égale à 2 mm, voire inférieure ou égale à 1,5 mm, et notamment comprise entre 500 µm et 1 mm.

Dans cet exemple, la deuxième couche 5 est réalisée en au moins un matériau polymère de type « backsheet ». Elle peut comporter un matériau polymère choisi parmi : le polycarbonate (PC), le polyméthacrylate de méthyle (PMMA), le polytéréphtalate d'éthylène (PET), le polypropylène (PP), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités. Avantageusement, elle est réalisée sous la forme d'un multicouche polymère et comporte une couche aluminisée.

Par ailleurs, dans cet exemple, la couche avant de matériau d'encapsulation 3a et la couche avant d'interface 2b sont toutes des films d'encapsulant de type A comme décrit précédemment.

En revanche, afin d'obtenir une résistance accrue aux chocs, la couche arrière de matériau d'encapsulation 3b est un film d'encapsulant de type B comme décrit précédemment. Ainsi, ses propriétés mécaniques sont renforcées.

Plus généralement, dans tous les exemples décrits ici en référence aux figures 3 à 6, l'invention prévoit d'avoir une couche avant de matériau d'encapsulation 3a avec un module de Young à 25°C strictement inférieur à 50 MPa, voire strictement inférieur à 20 MPa, voire supérieur à 2 MPa et strictement inférieur à 50 MPa, voire encore compris entre 10 et 20 MPa, et une couche arrière de matériau d'encapsulation avec un module de Young à 25°C strictement supérieur à 150 MPa, préférentiellement strictement supérieur à 200 MPa, préférentiellement encore strictement supérieur à 200 MPa et inférieur à 500 MPa, voire encore compris entre 250 et 350 MPa. En particulier, la couche avant de matériau d'encapsulation 3a est un film d'encapsulant de type A tandis que la couche arrière de matériau d'encapsulation 3b est un film d'encapsulant de type B.

Par l'utilisation d'un film d'encapsulant de type B pour la couche arrière de matériau d'encapsulation 3b, plutôt que l'utilisation d'un film encapsulant de type A, on peut ainsi éviter tout phénomène de casse du verre et des cellules photovoltaïques 4.

Il faut noter que la deuxième couche 5 peut en variante être formée par un panneau arrière 5 en matériau composite, comprenant une sous-couche principale, formant l'âme 9a du panneau arrière 5, et deux sous-couches de recouvrement, formant chacune une plaque 9b, 9c du panneau arrière 5, disposées de part et d'autre de l'âme 9a de sorte que l'âme 9a soit prise en sandwich entre les deux plaques 9b, 9c, l'âme 9a du panneau arrière 5 comportant une structure alvéolaire 12.

La figure 3A représente, schématiquement en coupe de façon plus détaillée, cette variante de la deuxième couche 5 formée dans l'exemple de la figure 3. Il est à noter encore que de façon alternative, la deuxième couche 5 pourrait comporter une couche de renforts à base de fibres, tissées ou non, notamment des fibres de verre, de carbone, d'aramide et/ou des fibres naturelles, notamment de chanvre, de lin et/ou de soie, entre autres.

Le module photovoltaïque 1 est obtenu par le biais d'une seule étape de lamination à chaud sous vide, par exemple à une température d'environ 150°C pendant environ 15 minutes. Il présente un poids surfacique de 4,4 kg/cm².

On a décrit précédemment que la couche avant de matériau d'encapsulation 3a et la couche avant d'interface 2b utilisent des films d'encapsulant de type A tandis que la couche arrière de matériau d'encapsulation 3b utilise un film d'encapsulant de type B. Il faut noter que la couche avant d'interface 2b peut aussi utiliser un film d'encapsulant de type B plutôt que de type A si l'on souhaite améliorer encore plus la résistance aux chocs du module photovoltaïque 1.

Par ailleurs, la figure 4 illustre un deuxième exemple de réalisation conforme à l'invention.

Dans cet exemple, à la différence de celui de la figure 3, la première couche 2 comporte également un deuxième ensemble avant 2d, 2e comprenant une couche avant d'interface 2d et une couche avant en verre, avantageusement en verre non trempé 2e. La couche avant en verre 2e présente une épaisseur e₂ₑ inférieure ou égale à 2 mm, voire inférieure ou égale à 1,5 mm, et notamment comprise entre 500 µm et 1 mm. Autrement dit, cet exemple de réalisation prévoit le doublement de l'épaisseur de verre dans la première couche 2. On obtient alors un module photovoltaïque 1 de poids surfacique égal à 6 kg/cm². La résistance aux chocs du module photovoltaïque 1 est encore plus améliorée.

De plus, la première couche avant d'interface 2b et la couche avant 3a d'encapsulation sont formées par des films d'encapsulant de type A, alors que la deuxième couche avant d'interface 2d et la couche arrière 3b d'encapsulation sont formées par des films d'encapsulant de type B.

Dans l'exemple de la figure 4, la première couche avant en verre 2b et la deuxième couche avant en verre 2e présentent la même épaisseur. En variante, il est possible d'utiliser des épaisseurs de verre différentes, par exemple une épaisseur e_{2b} de l'ordre de 500 µm et une épaisseur e₂ₑ de l'ordre de 300 µm. Ainsi, si on considère que 800 µm de verre peuvent répondre au besoin de tenue des cellules 4 aux chocs, il est possible d'utiliser par exemple un verre de 500 µm et un verre de 300 µm.

En effet, il est connu que les matériaux élastomères ont des propriétés d'amortissement des vibrations et des chocs. L'alternance de matériaux rigides avec des matériaux élastomères va ainsi permettre de modifier la vitesse de propagation des ondes de choc, du fait que la célérité d'une onde de choc est directement proportionnelle au module de Young et coefficients de Poisson du matériau utilisé. L'insertion de couches élastomères souples, entre des couches de matériaux plus rigides, permet donc de ralentir la propagation des ondes de choc. De plus, à chaque interface rencontrée, l'onde de choc peut être transmise et/ou réfléchie en partie. La répétition de l'alternance de ces couches polymères ayant des modules de Young différents permet donc d'une part le ralentissement des ondes de choc et d'autre part la diminution de l'intensité de ces dernières qui arrivent jusqu'aux cellules photovoltaïques.

Aussi, à quantité de verre équivalente, il peut être plus intéressant de répartir cette quantité entre au moins deux couches de verre d'épaisseurs différentes au lieu d'une seule couche de verre.

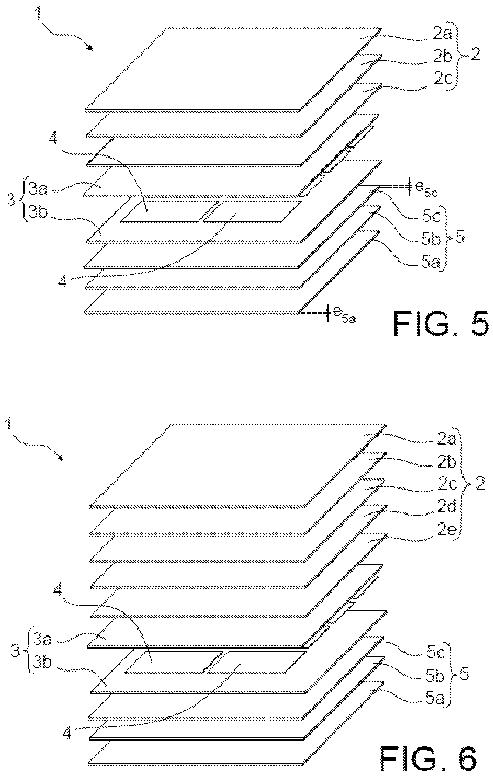

En outre, la figure 5 illustre encore un troisième exemple de réalisation dont le principe est d'utiliser en face arrière la même architecture d'encapsulation qu'en face avant, de manière symétrique. On peut ainsi obtenir un module photovoltaïque 1 bifacial et léger.

Ainsi, la deuxième couche 5 comporte ici une couche arrière réalisée en un matériau polymère 5a, dite « couche arrière polymère 5a », et un premier ensemble arrière 5b, 5c comprenant une couche arrière d'interface 5b et une couche arrière en verre, de préférence non trempé 5c.

La couche arrière en verre 5c présente une épaisseur e_{5c} de 550 µm, et la couche avant en verre 2c présente également une épaisseur e_{2c} de 550 µm.

La couche avant d'interface 2b, la couche arrière d'interface 5b et la couche d'encapsulation arrière 3b sont ici des films d'encapsulant de type B, tandis que la couche d'encapsulation avant 3a est un film d'encapsulant de type A.

Par ailleurs, la figure 6 illustre un quatrième exemple de réalisation correspondant à une variante de l'exemple de la figure 5 dans laquelle l'utilisation de verres minces de préférence non trempés en face avant et en face arrière est réalisée de manière asymétrique.

En particulier, deux verres minces 2c et 2e peuvent être utilisés en face avant d'épaisseurs identiques ou différentes, et un verre mince 5c peut être utilisé en face arrière. Plus précisément ici, une première couche avant en verre 2c présente une épaisseur e_{2c} de 500 µm, une deuxième couche avant en verre 2e présente une épaisseur e₂ₑ de 300 µm, et une première couche arrière en verre 5c présente une épaisseur e_{5c} de 550 µm.

De plus, la première couche avant d'interface 2b, la deuxième couche avant d'interface 2d, la couche arrière d'interface 5b, et la couche d'encapsulation arrière 3b sont ici des films d'encapsulant de type B tandis que la couche d'encapsulation avant 3a est un film d'encapsulant de type A.

Dans tous les exemples décrits précédemment, la couche avant polymère 2a et la couche arrière polymère 5a présentent une épaisseur e₂ₐ, e₅ₐ de l'ordre de 50 µm.

Les couches avant d'interface 2b, 2d et la couche arrière d'interface 5b présentent une épaisseur e_{2b}, e_{2d}, e_{5b} de l'ordre de 600 µm.

Bien entendu, l'invention n'est pas limitée aux exemples de réalisation qui viennent d'être décrits. Diverses modifications peuvent y être apportées par l'homme du métier.

En particulier, ces exemples de réalisation peuvent être déclinés selon diverses variantes en utilisant un ou plusieurs des matériaux mentionnés précédemment pour former la première couche 2 et la deuxième couche 5.

## Revendications

1. Module photovoltaïque (1) obtenu à partir d'un empilement comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4), obtenu par la réunion d'une couche avant de matériau d'encapsulation (3a) et d'une couche arrière de matériau d'encapsulation (3b) de part et d'autre des cellules photovoltaïques (4), la couche avant de matériau d'encapsulation (3a) étant située entre la première couche (2) et les cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches, la première couche (2) comportant :
- une couche avant réalisée en au moins un matériau polymère (2a), dite « couche avant polymère (2a) », et
- au moins un ensemble avant (2b, 2c ; 2d, 2e) comprenant une couche avant d'interface (2b ; 2d) et une couche avant en verre (2c ; 2e), la couche avant en verre (2c ; 2e) présentant une épaisseur (e_{2c} ; e₂ₑ) inférieure ou égale à 2 mm, ledit au moins un ensemble avant (2b, 2c ; 2d, 2e) étant situé entre la couche avant polymère (2a) et l'ensemble encapsulant (3), et la couche avant d'interface (2b ; 2d) dudit au moins un ensemble avant (2b, 2c ; 2d, 2e) étant située entre la couche avant polymère (2a) et la couche avant en verre (2c ; 2e),
**caractérisé**
**en ce que** la couche avant de matériau d'encapsulation (3a) est formée par au moins une couche comportant au moins un matériau d'encapsulation de type polymère ayant un module de Young à 25°C compris entre 2 et 20 MPa,
et **en ce que** la couche arrière de matériau d'encapsulation (3b) est formée par au moins une couche comportant au moins un matériau d'encapsulation de type polymère ayant un module de Young à 25°C strictement supérieur à 200 MPa.

2. Module selon la revendication 1, **caractérisé en ce que** la couche avant de matériau d'encapsulation (3a) est formée par au moins une couche comportant au moins un matériau d'encapsulation de type polymère ayant un module de Young à 25°C compris entre 10 et 20 MPa, et **en ce que** la couche arrière de matériau d'encapsulation (3b) est formée par au moins une couche comportant au moins un matériau d'encapsulation de type polymère ayant un module de Young à 25°C strictement supérieur à 200 MPa et inférieur à 500 MPa, notamment compris entre 250 et 350 MPa.

3. Module selon la revendication 1 ou 2, **caractérisé en ce que** la couche avant en verre (2c ; 2e) présente une épaisseur (e_{2c} ; e₂ₑ) inférieure ou égale à 1,5 mm, notamment comprise entre 500 µm et 1 mm.

4. Module selon l'une des revendications précédentes, **caractérisé en ce que** la couche avant en verre (2c ; 2e) est réalisée en verre non trempé.

5. Module selon l'une des revendications 1 à 4, **caractérisé en ce que** la deuxième couche (5) est réalisée en au moins un matériau polymère, notamment choisi parmi : le polycarbonate (PC), le polyméthacrylate de méthyle (PMMA), le polytéréphtalate d'éthylène (PET), le polypropylène (PP), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE), l'éthylène propylène fluoré (FEP) et/ou un film multicouche comprenant un ou plusieurs des polymères précités.

6. Module selon l'une des revendications 1 à 4, **caractérisé en ce que** la deuxième couche (5) comporte :
- une couche arrière formant un panneau arrière (5) en matériau composite, comprenant une sous-couche principale, formant l'âme (9a) du panneau arrière (5), et deux sous-couches de recouvrement, formant chacune une plaque (9b, 9c) du panneau arrière (5), disposées de part et d'autre de l'âme (9a) de sorte que l'âme (9a) soit prise en sandwich entre les deux plaques (9b, 9c), l'âme (9a) du panneau arrière (5) comportant une structure alvéolaire (12).

7. Module selon l'une des revendications 1 à 4, **caractérisé en ce que** la deuxième couche (5) comporte :
- une couche arrière réalisée en au moins un matériau polymère (5a), dite « couche arrière polymère (5a) », et
- au moins un ensemble arrière (5b, 5c) comprenant une couche arrière d'interface (5b) et une couche arrière en verre (5c), la couche arrière en verre (5c) présentant notamment une épaisseur (e_{5c}) inférieure ou égale à 2 mm, notamment inférieure ou égale à 1,5 mm, notamment comprise entre 500 µm et 1 mm, et étant notamment réalisée en verre non trempé,
ledit au moins un ensemble arrière (5b, 5c) étant situé entre la couche arrière polymère (5a) et l'ensemble encapsulant (3), et la couche arrière d'interface (5b) dudit au moins un ensemble arrière (5b, 5c) étant située entre la couche arrière polymère (5a) et la couche arrière en verre (5c).

8. Module selon l'une des revendications 1 à 4, **caractérisé en ce que** la deuxième couche (5) comporte une couche de renforts à base de fibres, notamment des fibres de verre, de carbone, d'aramide et/ou des fibres naturelles, notamment de chanvre, de lin et/ou de soie.

9. Module selon l'une quelconque des revendications précédentes, **caractérisé en ce que** :
- la couche avant polymère (2a) et/ou la couche arrière polymère (5a) présentent une épaisseur (e₂ₐ, e₅ₐ) comprise entre 15 µm et 300 µm, notamment entre 20 µm et 50 µm, et/ou,
- la couche avant d'interface (2b ; 2d) et/ou la couche arrière d'interface (5b) présentent une épaisseur (e_{2b}, e_{2d} ; e_{5b}) comprise entre 50 µm et 600 µm, notamment entre 400 µm et 600 µm, notamment entre 400 µm et 500 µm.

10. Module selon l'une quelconque des revendications précédentes, **caractérisé en ce que** la couche avant d'interface (2b ; 2d) et/ou l'éventuelle couche arrière d'interface (5b) sont formés par au moins une couche comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

11. Module selon l'une quelconque des revendications précédentes, **caractérisé en ce que** la couche avant de matériau d'encapsulation (3a) est formée par au moins une couche comportant au moins un matériau d'encapsulation de type polymère choisi parmi : le poly(éthylène-acétate de vinyle) (EVA), les acétals de vinyle, tels que les polyvinylbutyrals (PVB), les polyuréthanes, les élastomères de silicone, les élastomères à base de polyoléfine thermoplastique réticulée et/ou les élastomères à base de polyoléfine thermoplastique réticulée (TPO).

12. Module selon l'une quelconque des revendications précédentes, **caractérisé en ce que** la couche arrière de matériau d'encapsulation (3b) est formée par au moins une couche comportant au moins un matériau d'encapsulation de type polymère choisi parmi : les copolymères d'acides, les ionomères, les chlorures de polyvinyle et/ou les polyéthylènes.

13. Module selon l'une quelconque des revendications précédentes, **caractérisé en ce que** la première couche (2) comporte :
- un premier ensemble avant (2b, 2c) comprenant une couche avant d'interface (2b) et une couche avant en verre (2c), la couche avant en verre (2c) présentant une épaisseur (e_{2c}) inférieure ou égale à 2 mm,
- un deuxième ensemble avant (2d, 2e) comprenant une couche avant d'interface (2d) et une couche avant en verre (2e), la couche avant en verre (2e) présentant une épaisseur (e₂ₑ) inférieure ou égale à 2 mm,
le premier ensemble avant (2b, 2c) étant situé entre la couche avant polymère (2a) et le deuxième ensemble avant (2d, 2e), lui-même situé entre le premier ensemble avant (2b, 2c) et l'ensemble encapsulant (3),
l'épaisseur (e_{2c}) de la couche avant en verre (2c) du premier ensemble avant (2b, 2c) et l'épaisseur (e₂ₑ) de la couche avant en verre (2e) du deuxième ensemble avant (2d, 2e) étant notamment différentes, l'épaisseur (e_{2c}) de la couche avant en verre (2c) du premier ensemble avant (2b, 2c) étant notamment supérieure à l'épaisseur (e₂ₑ) de la couche avant en verre (2e) du deuxième ensemble avant (2d, 2e).

14. Module selon l'une quelconque des revendications précédentes, **caractérisé en ce que** la deuxième couche (5) comporte :
- une couche arrière réalisée en au moins un matériau polymère (5a), dite « couche arrière polymère (5a) », et
- un premier ensemble arrière (5b, 5c) comprenant une couche arrière d'interface (5b) et une couche arrière en verre (5c), la couche arrière en verre (5c) présentant notamment une épaisseur (e_{5c}) inférieure ou égale à 2 mm, notamment inférieure ou égale à 1,5 mm, notamment comprise entre 500 µm et 1 mm, et étant notamment réalisée en verre non trempé,
- un deuxième ensemble arrière comprenant une couche arrière d'interface et une couche arrière en verre, la couche arrière en verre présentant notamment une épaisseur inférieure ou égale à 2 mm, notamment inférieure ou égale à 1,5 mm, notamment comprise entre 500 µm et 1 mm, et étant notamment réalisée en verre non trempé,
ledit premier ensemble arrière (5b, 5c) étant situé entre la couche arrière polymère (5a) et le deuxième ensemble arrière, lui-même situé entre le premier ensemble arrière (5b, 5c) et l'ensemble encapsulant (3).

15. Procédé de réalisation d'un module photovoltaïque (1) selon l'une quelconque des revendications précédentes, à partir d'un empilement comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4), obtenu par la réunion d'une couche avant de matériau d'encapsulation (3a) et d'une couche arrière de matériau d'encapsulation (3b) de part et d'autre des cellules photovoltaïques (4), la couche avant de matériau d'encapsulation (3a) étant située entre la première couche (2) et les cellules photovoltaïques (4),
- une deuxième couche (5), l'ensemble encapsulant (3) et la pluralité de cellules photovoltaïques (4) étant situés entre les première (2) et deuxième (5) couches, la première couche (2) comportant :
- une couche avant réalisée en au moins un matériau polymère (2a), dite « couche avant polymère (2a) », et
- au moins un ensemble avant (2b, 2c ; 2d, 2e) comprenant une couche avant d'interface (2b ; 2d) et une couche avant en verre (2c ; 2e), la couche avant en verre (2c ; 2e) présentant une épaisseur (e_{2c} ; e₂ₑ) inférieure ou égale à 2 mm,
ledit au moins un ensemble avant (2b, 2c ; 2d, 2e) étant situé entre la couche avant polymère (2a) et l'ensemble encapsulant (3), et la couche avant d'interface (2b ; 2d) dudit au moins un ensemble avant (2b, 2c ; 2d, 2e) étant située entre la couche avant polymère (2a) et la couche avant en verre (2c ; 2e),
le procédé comportant l'étape de lamination à chaud et sous vide des couches constitutives de l'empilement pour obtenir le module,
**caractérisé en ce que** la couche avant de matériau d'encapsulation (3a) est formée par au moins une couche comportant au moins un matériau d'encapsulation de type polymère ayant un module de Young à 25°C compris entre 2 et 20 MPa,
et **en ce que** la couche arrière de matériau d'encapsulation (3b) est formée par au moins une couche comportant au moins un matériau d'encapsulation de type polymère ayant un module de Young à 25°C strictement supérieur à 200 MPa.

## Patentansprüche

1. Photovoltaikmodul (1), das ausgehend von einem Schichtstapel erhalten wurde, der Folgendes umfasst:
- eine erste transparente Schicht (2), die die Vorderseite des Photovoltaikmoduls (1) bildet und dazu bestimmt ist, einen Lichtstrom zu empfangen,
- eine Vielzahl von photovoltaischen Zellen (4), die nebeneinander angeordnet und elektrisch miteinander verbunden sind,
- eine die Vielzahl von photovoltaischen Zellen (4) einkapselnde Anordnung (3), die durch das Zusammenbringen einer vorderen Schicht aus Einkapselungsmaterial (3a) und einer hinteren Schicht aus Einkapselungsmaterial (3b) auf beiden Seiten der photovoltaischen Zellen (4) erhalten wird, wobei die vordere Schicht aus Einkapselungsmaterial (3a) zwischen der ersten Schicht (2) und den photovoltaischen Zellen (4) angeordnet ist,
- eine zweite Schicht (5), die die Rückseite des Photovoltaikmoduls (1) bildet, wobei die einkapselnde Anordnung (3) und die Vielzahl von photovoltaischen Zellen (4) zwischen der ersten (2) und der zweiten (5) Schicht angeordnet sind,
wobei die erste Schicht (2) Folgendes umfasst :
- eine vordere Schicht, die aus mindestens einem polymeren Material (2a) hergestellt ist, die so genannte "vordere Polymerschicht (2a)", und
- mindestens eine vordere Anordnung (2b, 2c; 2d, 2e), die eine vordere Grenzflächenschicht (2b; 2d) und eine vordere Glasschicht (2c; 2e) umfasst, wobei die vordere Glasschicht (2c; 2e) eine Dicke (e_{2c}; e₂ₑ) von weniger als oder gleich 2 mm aufweist,
wobei die mindestens eine vordere Anordnung (2b, 2c; 2d, 2e) zwischen der vorderen Polymerschicht (2a) und der einkapselnden Anordnung (3) angeordnet ist, und die vordere Grenzflächenschicht (2b; 2d) der mindestens einen vorderen Anordnung (2b, 2c; 2d, 2e) zwischen der vorderen Polymerschicht (2a) und der vorderen Glasschicht (2c; 2e) angeordnet ist,
**dadurch gekennzeichnet, dass** die vordere Schicht aus Einkapselungsmaterial (3a) durch mindestens eine Schicht gebildet ist, die mindestens ein Einkapselungsmaterial vom Polymertyp mit einem Young'schen Modul bei 25°C zwischen 2 und 20 MPa umfasst,
und dass die hintere Schicht aus Einkapselungsmaterial (3b) durch mindestens eine Schicht gebildet ist, die mindestens ein Einkapselungsmaterial vom Polymertyp mit einem Young'schen Modul bei 25°C von strikt über 200 MPa umfasst.

2. Modul nach Anspruch 1, **dadurch gekennzeichnet, dass** die vordere Schicht aus Einkapselungsmaterial (3a) durch mindestens eine Schicht gebildet ist, die mindestens ein Einkapselungsmaterial vom Polymertyp mit einem Young'schen Modul bei 25°C zwischen 10 und 20 MPa umfasst, und dass die hintere Schicht aus Einkapselungsmaterial (3b) durch mindestens eine Schicht gebildet ist, die mindestens ein Einkapselungsmaterial vom Polymertyp mit einem Young'schen Modul bei 25°C strikt über 200 MPa und unter 500 MPa, insbesondere zwischen 250 und 350 MPa, umfasst.

3. Modul nach Anspruch 1 oder 2, **dadurch gekennzeichnet, dass** die vordere Glasschicht (2c; 2e) eine Dicke (e_{2c}; e₂ₑ) von weniger als oder gleich 1,5 mm, insbesondere zwischen 500 µm und 1 mm, aufweist.

4. Modul nach einem der vorstehenden Ansprüche, **dadurch gekennzeichnet, dass** die vordere Glasschicht (2c; 2e) aus nicht gehärtetem Glas hergestellt ist.

5. Modul nach einem der Ansprüche 1 bis 4, **dadurch gekennzeichnet, dass** die zweite Schicht (5) aus mindestens einem polymeren Material hergestellt ist, das insbesondere ausgewählt ist aus: Polycarbonat (PC), Polymethylmethacrylat (PMMA), Polyethylenterephthalat (PET), Polypropylen (PP), Polyamid (PA), einem fluorierten Polymer, insbesondere Polyvinylfluorid (PVF) oder Polyvinylidenfluorid (PVDF), Ethylentetrafluorethylen (ETFE), Ethylenchlortrifluorethylen (ECTFE), Polytetrafluorethylen (PTFE), Polychlortrifluorethylen (PCTFE), fluoriertem Ethylenpropylen (FEP) und/oder einer mehrschichtigen Folie, die eines oder mehrere der vorgenannten Polymere umfasst.

6. Modul nach einem der Ansprüche 1 bis 4, **dadurch gekennzeichnet, dass** die zweite Schicht (5) Folgendes umfasst:
- eine hintere Schicht, die eine Rückwand (5) aus Verbundmaterial bildet, umfassend eine Hauptunterschicht, die den Kern (9a) der Rückwand (5) bildet, und zwei Deckunterschichten, die jeweils eine Platte (9b, 9c) der Rückwand (5) bilden, die auf beiden Seiten des Kerns (9a) angeordnet sind, so dass der Kern (9a) zwischen den beiden Platten (9b, 9c) sandwichartig eingeschlossen ist, wobei der Kern (9a) der Rückwand (5) eine Wabenstruktur (12) aufweist.

7. Modul nach einem der Ansprüche 1 bis 4, **dadurch gekennzeichnet, dass** die zweite Schicht (5) Folgendes umfasst:
- eine hintere Schicht, die aus mindestens einem polymeren Material (5a) hergestellt ist, die so genannte "hintere Polymerschicht (5a)", und
- mindestens eine hintere Anordnung (5b, 5c), die eine hintere Grenzflächenschicht (5b) und eine hintere Glasschicht (5c) umfasst, wobei die hintere Glasschicht (5c) insbesondere eine Dicke (e_{5c}) von weniger als oder gleich 2 mm, insbesondere weniger als oder gleich 1,5 mm, insbesondere zwischen 500 µm und 1 mm, aufweist und insbesondere aus nicht gehärtetem Glas hergestellt ist,
wobei die mindestens eine hintere Anordnung (5b, 5c) zwischen der hinteren Polymerschicht (5a) und der einkapselnden Anordnung (3) angeordnet ist, und die hintere Grenzflächenschicht (5b) der mindestens einen hinteren Anordnung (5b, 5c) zwischen der hinteren Polymerschicht (5a) und der hinteren Glasschicht (5c) angeordnet ist

8. Modul nach einem der Ansprüche 1 bis 4, **dadurch gekennzeichnet, dass** die zweite Schicht (5) eine Verstärkungsschicht auf Faserbasis, insbesondere Glas-, Kohlenstoff-, Aramid- und/oder Naturfasern, insbesondere Hanf-, Flachs- und/oder Seidenfasern, umfasst.

9. Modul nach einem der vorstehenden Ansprüche, **dadurch gekennzeichnet, dass**:
- die vordere Polymerschicht (2a) und/oder die hintere Polymerschicht (5a) eine Dicke (e₂ₐ, e₅ₐ) zwischen 15 µm und 300 µm, insbesondere zwischen 20 µm und 50 µm, aufweisen,
und/oder
- die vordere Grenzflächenschicht (2b; 2d) und/oder die hintere Grenzflächenschicht (5b) eine Dicke (e_{2b}, e_{2d}; e_{5b}) zwischen 50 µm und 600 µm, insbesondere zwischen 400 µm und 600 µm, insbesondere zwischen 400 µm und 500 µm, aufweisen.

10. Modul nach einem der vorstehenden Ansprüche, **dadurch gekennzeichnet, dass** die vordere Grenzflächenschicht (2b; 2d) und/oder die mögliche hintere Grenzflächenschicht (5b) durch mindestens eine Schicht gebildet sind, die mindestens ein Einkapselungsmaterial vom Polymertyp umfasst, das ausgewählt ist aus: Säurecopolymeren, Ionomeren, Poly(ethylenvinylacetat) (EVA), Vinylacetalen, wie Polyvinylbutyralen (PVB), Polyurethanen, Polyvinylchloriden, Polyethylenen, wie linearen Polyethylenen mit niedriger Dichte, elastomeren Polyolefinen aus Copolymeren, Copolymeren aus α-Olefinen und α-, β- Carbonsäure- bis Ethylensäureestern, wie Ethylen-Methylacrylat-Copolymeren und Ethylen-Butylacrylat-Copolymeren, Silikonelastomeren und/oder Elastomeren auf Basis von vernetztem thermoplastischem Polyolefin.

11. Modul nach einem der vorstehenden Ansprüche, **dadurch gekennzeichnet, dass** die vordere Schicht aus Einkapselungsmaterial (3a) durch mindestens eine Schicht gebildet ist, die mindestens ein Einkapselungsmaterial vom Polymertyp umfasst, das ausgewählt ist aus: Poly(ethylenvinylacetat) (EVA), Vinylacetalen wie Polyvinylbutyralen (PVB), Polyurethanen, Silikonelastomeren, Elastomeren auf Basis von vernetztem thermoplastischem Polyolefin und/oder Elastomeren auf Basis von vernetztem thermoplastischem Polyolefin (TPO).

12. Modul nach einem der vorstehenden Ansprüche, **dadurch gekennzeichnet, dass** die hintere Schicht aus Einkapselungsmaterial (3b) durch mindestens eine Schicht gebildet ist, die mindestens ein Einkapselungsmaterial vom Polymertyp umfasst, das ausgewählt ist aus: Säurecopolymeren, Ionomeren, Polyvinylchloriden und/oder Polyethylenen.

13. Modul nach einem der vorstehenden Ansprüche, **dadurch gekennzeichnet, dass** die erste Schicht (2) Folgendes umfasst:
- eine erste vordere Anordnung (2b, 2c), die eine vordere Grenzflächenschicht (2b) und eine vordere Glasschicht (2c) umfasst, wobei die vordere Glasschicht (2c) eine Dicke (e_{2c}) von weniger als oder gleich 2 mm aufweist,
- eine zweite vordere Anordnung (2d, 2e), die eine vordere Grenzflächenschicht (2d) und eine vordere Glasschicht (2e) umfasst, wobei die vordere Glasschicht (2e) eine Dicke (e₂ₑ) von weniger als oder gleich 2 mm aufweist,
wobei die erste vordere Anordnung (2b, 2c) zwischen der vorderen Polymerschicht (2a) und der zweiten vorderen Anordnung (2d, 2e) angeordnet ist, die ihrerseits zwischen der ersten vorderen Anordnung (2b, 2c) und der einkapselnden Anordnung (3) angeordnet ist,
wobei die Dicke (e_{2c}) der vorderen Glasschicht (2c) der ersten vorderen Anordnung (2b, 2c) und die Dicke (e₂ₑ) der vorderen Glasschicht (2e) der zweiten vorderen Anordnung (2d, 2e) insbesondere unterschiedlich sind, wobei die Dicke (e_{2c}) der vorderen Glasschicht (2c) der ersten vorderen Anordnung (2b, 2c) insbesondere größer ist als die Dicke (e₂ₑ) der vorderen Glasschicht (2e) der zweiten vorderen Anordnung (2d, 2e).

14. Modul nach einem der vorstehenden Ansprüche, **dadurch gekennzeichnet, dass** die zweite Schicht (5) Folgendes umfasst:
- eine hintere Schicht, die aus mindestens einem polymeren Material (5a) hergestellt ist, die so genannte "hintere Polymerschicht (5a)", und
- eine erste hintere Anordnung (5b, 5c), die eine hintere Grenzflächenschicht (5b) und eine hintere Glasschicht (5c) umfasst, wobei die hintere Glasschicht (5c) insbesondere eine Dicke (e_{5c}) von weniger als oder gleich 2 mm, insbesondere weniger als oder gleich 1,5 mm, insbesondere zwischen 500 µm und 1 mm, aufweist und insbesondere aus nicht gehärtetem Glas hergestellt ist,
- eine zweite hintere Anordnung, die eine hintere Grenzflächenschicht und eine hintere Glasschicht umfasst, wobei die hintere Glasschicht insbesondere eine Dicke von weniger als oder gleich 2 mm, insbesondere weniger als oder gleich 1,5 mm, insbesondere zwischen 500 µm und 1 mm, aufweist und insbesondere aus nicht gehärtetem Glas hergestellt ist,
wobei die erste hintere Anordnung (5b, 5c) zwischen der hinteren Polymerschicht (5a) und der zweiten hinteren Anordnung angeordnet ist, die ihrerseits zwischen der ersten hinteren Anordnung (5b, 5c) und der einkapselnden Anordnung (3) angeordnet ist.

15. Verfahren zur Herstellung eines Photovoltaikmoduls (1) nach einem der vorstehenden Ansprüche, ausgehend von einem Schichtstapel umfassend:
- eine erste transparente Schicht (2), die die Vorderseite des Photovoltaikmoduls (1) bildet und dazu bestimmt ist, einen Lichtstrom zu empfangen,
- eine Vielzahl von photovoltaischen Zellen (4), die nebeneinander angeordnet und elektrisch miteinander verbunden sind,
- eine die Vielzahl von photovoltaischen Zellen (4) einkapselnde Anordnung (3), die durch das Zusammenbringen einer vorderen Schicht aus Einkapselungsmaterial (3a) und einer hinteren Schicht aus Einkapselungsmaterial (3b) auf beiden Seiten der photovoltaischen Zellen (4) erhalten wird, wobei die vordere Schicht aus Einkapselungsmaterial (3a) zwischen der ersten Schicht (2) und den photovoltaischen Zellen (4) angeordnet ist,
- wobei eine zweite Schicht (5), die einkapselnde Anordnung (3) und die Vielzahl von photovoltaischen Zellen (4) zwischen der ersten (2) und der zweiten (5) Schicht angeordnet sind,
wobei die erste Schicht (2) Folgendes umfasst:
- eine vordere Schicht, die aus mindestens einem polymeren Material (2a) hergestellt ist, die so genannte "vordere Polymerschicht (2a)", und
- mindestens eine vordere Anordnung (2b, 2c; 2d, 2e), die eine vordere Grenzflächenschicht (2b; 2d) und eine vordere Glasschicht (2c; 2e) umfasst, wobei die vordere Glasschicht (2c; 2e) eine Dicke (e_{2c}; e₂ₑ) von weniger als oder gleich 2 mm aufweist,
wobei die mindestens eine vordere Anordnung (2b, 2c; 2d, 2e) zwischen der vorderen Polymerschicht (2a) und der einkapselnden Anordnung (3) angeordnet ist, und die vordere Grenzflächenschicht (2b; 2d) der mindestens einen vorderen Anordnung (2b, 2c; 2d, 2e) zwischen der vorderen Polymerschicht (2a) und der vorderen Glasschicht (2c; 2e) angeordnet ist,
wobei das Verfahren den Schritt des Heißlaminierens der den Schichtstapel bildenden Schichten unter Vakuum umfasst, um das Modul zu erhalten,
**dadurch gekennzeichnet, dass** die vordere Schicht aus Einkapselungsmaterial (3a) durch mindestens eine Schicht gebildet ist, die mindestens ein Einkapselungsmaterial vom Polymertyp mit einem Young'schen Modul bei 25°C zwischen 2 und 20 MPa umfasst,
und dass die hintere Schicht aus Einkapselungsmaterial (3b) durch mindestens eine Schicht gebildet ist, die mindestens ein Einkapselungsmaterial vom Polymertyp mit einem Young'schen Modul bei 25°C von strikt über 200 MPa umfasst.

## Claims

1. A photovoltaic module (1) obtained from a stack comprising:
- a first transparent layer (2) forming the front face of the photovoltaic module (1), intended to receive a luminous flux,
- a plurality of photovoltaic cells (4) disposed side by side and electrically connected to each other,
- an assembly (3) encapsulating the plurality of photovoltaic cells (4), obtained by joining a front layer of an encapsulating material (3a) and a rear layer of an encapsulating material (3b) on either side of the photovoltaic cells (4), the front layer of an encapsulating material (3a) being located between the first layer (2) and the photovoltaic cells (4),
- a second layer (5) forming the rear face of the photovoltaic module (1), the encapsulating assembly (3) and the plurality of photovoltaic cells (4) being located between the first (2) and second (5) layers,
the first layer (2) comprising:
- a front layer made of at least one polymer material (2a), called "polymer front layer (2a)", and
- at least one front assembly (2b, 2c; 2d, 2e) comprising an interface front layer (2b; 2d) and a glass front layer (2c; 2e), the glass front layer (2c; 2e) having a thickness (e_{2c}; e₂ₑ) less than or equal to 2 mm,
said at least one front assembly (2b, 2c; 2d, 2e) being located between the polymer front layer (2a) and the encapsulating assembly (3), and the interface front layer (2b; 2d) of said at least one front assembly (2b, 2c; 2d, 2e) being located between the polymer front layer (2a) and the glass front layer (2c; 2e),
**characterized in that** the front layer of an encapsulating material (3a) is formed by at least one layer including at least one polymer-type encapsulating material having a Young's modulus at 25°C comprised between 2 and 20 MPa,
and **in that** the rear layer of an encapsulating material (3b) is formed by at least one layer including at least one polymer-type encapsulating material having a Young's modulus at 25°C of strictly greater than 200 MPa.

2. The module according to claim 1, **characterized in that** the front layer of an encapsulating material (3a) is formed by at least one layer including at least one polymer-type encapsulating material having a Young's modulus at 25°C comprised between 10 and 20 MPa, and **in that** the rear layer of an encapsulating material (3b) is formed by at least one layer including at least one polymer-type encapsulating material having a Young's modulus at 25°C of strictly greater than 200 MPa and less than 500 MPa, in particular comprised between 250 and 350 MPa.

3. The module according to claim 1 or 2, **characterized in that** the glass front layer (2c; 2e) has a thickness (e_{2c}; e₂ₑ) less than or equal to 1.5 mm, in particular comprised between 500 µm and 1 mm.

4. The module according to one of the preceding claims, **characterized in that** the glass front layer (2c; 2e) is made of non-tempered glass.

5. The module according to one of claims 1 to 4, **characterized in that** the second layer (5) is made of at least one polymer material, in particular selected from: polycarbonate (PC), polymethyl methacrylate (PMMA), polyethylene terephthalate (PET), polypropylene (PP), polyamide (PA), a fluorinated polymer, in particular polyvinyl fluoride (PVF) or polyvinylidene fluoride (PVDF), ethylene tetrafluoroethylene (ETFE), ethylene chlorotrifluoroethylene (ECTFE), polytetrafluoroethylene (PTFE), polychlorotrifluoroethylene (PCTFE), fluorinated ethylene propylene (FEP) and/or a multilayer film comprising one or more of the aforementioned polymers.

6. The module according to one of claims 1 to 4, **characterized in that** the second layer (5) includes:
- a rear layer forming a rear panel (5) made of composite material, comprising a main sub-layer, forming the core (9a) of the rear panel (5), and two covering sub-layers, each forming a plate (9b, 9c) of the rear panel (5), disposed on either side of the core (9a) so that the core (9a) is sandwiched between the two plates (9b, 9c), the core (9a) of the rear panel (5) including a cellular structure (12).

7. The module according to one of claims 1 to 4, **characterized in that** the second layer (5) includes:
- a rear layer made of at least one polymer material (5a), called "polymer rear layer (5a)", and
- at least one rear assembly (5b, 5c) comprising an interface rear layer (5b) and a glass rear layer (5c), the glass rear layer (5c) having in particular a thickness (e_{5c}) less than or equal to 2 mm, in particular less than or equal to 1.5 mm, in particular comprised between 500 µm and 1 mm, and being in particular made of non-tempered glass,
said at least one rear assembly (5b, 5c) being located between the polymer rear layer (5a) and the encapsulating assembly (3), and the interface rear layer (5b) of said at least one rear assembly (5b, 5c) being located between the polymer rear layer (5a) and the glass rear layer (5c).

8. The module according to one of claims 1 to 4, **characterized in that** the second layer (5) includes a layer of reinforcements based on fibers, in particular glass fibers, carbon fibers, aramid fibers and/or natural fibers, in particular hemp, linen and/or silk.

9. The module according to any one of the preceding claims, **characterized in that**:
- the polymer front layer (2a) and/or the polymer rear layer (5a) have a thickness (e₂ₐ, e₅ₐ) comprised between 15 µm and 300 µm, in particular between 20 µm and 50 µm, and/or,
- the interface front layer (2b; 2d) and/or the interface rear layer (5b) have a thickness (e_{2b}, e_{2d}; e_{5b}) comprised between 50 µm and 600 µm, in particular between 400 µm and 600 µm, in particular between 400 µm and 500 µm.

10. The module according to any one of the preceding claims, **characterized in that** the interface front layer (2b; 2d) and/or the optional interface rear layer (5b) are formed by at least one layer including at least one polymer-type encapsulating material selected from: acid copolymers, ionomers, poly(ethylene-vinyl acetate) (EVA), vinyl acetals, such as polyvinyl butyrals (PVB), polyurethanes, polyvinyl chlorides, polyethylenes, such as linear low density polyethylenes, polyolefin elastomers of copolymers, copolymers of α-olefins and α-, β-ethylenic carboxylic acid esters, such as ethylene-methyl acrylate copolymers and ethylene-butyl acrylate copolymers, silicone elastomers and/or elastomers based on crosslinked thermoplastic polyolefin.

11. The module according to any one of the preceding claims, **characterized in that** the front layer of an encapsulating material (3a) is formed by at least one layer including at least one polymer-type encapsulating material selected from: poly(ethylene-vinyl acetate) (EVA), vinyl acetals, such as polyvinyl butyrals (PVB), polyurethanes, silicone elastomers, elastomers based on crosslinked thermoplastic polyolefin and/or elastomers based on crosslinked thermoplastic polyolefin (TPO).

12. The module according to any one of the preceding claims, **characterized in that** the rear layer of an encapsulating material (3b) is formed by at least one layer including at least one polymer-type encapsulating material selected from: acid copolymers, ionomers, polyvinyl chlorides and/or polyethylenes.

13. The module according to any one of the preceding claims, **characterized in that** the first layer (2) includes:
- a first front assembly (2b, 2c) comprising an interface front layer (2b) and a glass front layer (2c), the glass front layer (2c) with a thickness (e_{2c}) less than or equal to 2 mm,
- a second front assembly (2d, 2e) comprising an interface front layer (2d) and a glass front layer (2e), the glass front layer (2e) with a thickness (e₂ₑ) less than or equal to 2 mm,
the first front assembly (2b, 2c) being located between the polymer front layer (2a) and the second front assembly (2d, 2e), in turn located between the first front assembly (2b, 2c) and the encapsulating assembly (3),
the thickness (e_{2c}) of the glass front layer (2c) of the first front assembly (2b, 2c) and the thickness (e₂ₑ) of the glass front layer (2e) of the second front assembly (2d, 2e) being in particular different, the thickness (e_{2c}) of the glass front layer (2c) of the first front assembly (2b, 2c) being in particular greater than the thickness (e₂ₑ) of the glass front layer (2e) of the second front assembly (2d, 2e).

14. The module according to any one of the preceding claims, **characterized in that** the second layer (5) includes:
- a rear layer made of at least one polymer material (5a), called "polymer rear layer (5a)", and
- a first rear assembly (5b, 5c) comprising an interface rear layer (5b) and a glass rear layer (5c), the glass rear layer (5c) having in particular a thickness (e_{5c}) less than or equal to 2 mm, in particular less than or equal to 1.5 mm, in particular comprised between 500 µm and 1 mm, and being in particular made of non-tempered glass,
- a second rear assembly comprising an interface rear layer and a glass rear layer, the glass rear layer having in particular a thickness less than or equal to 2 mm, in particular less than or equal to 1.5 mm, in particular comprised between 500 µm and 1 mm, and being in particular made of non-tempered glass,
said first rear assembly (5b, 5c) being located between the polymer rear layer (5a) and the second rear assembly, in turn located between the first rear assembly (5b, 5c) and the encapsulating assembly (3).

15. A method for producing a photovoltaic module (1) according to any one of the preceding claims, from a stack including:
- a first transparent layer (2) forming the front face of the photovoltaic module (1), intended to receive a luminous flux,
- a plurality of photovoltaic cells (4) disposed side by side and electrically connected to each other,
- an assembly (3) encapsulating the plurality of photovoltaic cells (4), obtained by joining a front layer of an encapsulating material (3a) and a rear layer of an encapsulating material (3b) on either side of the photovoltaic cells (4), the front layer of an encapsulating material (3a) being located between the first layer (2) and the photovoltaic cells (4),
- a second layer (5), the encapsulating assembly (3) and the plurality of photovoltaic cells (4) being located between the first (2) and second (5) layers,
the first layer (2) comprising:
- a front layer made of at least one polymer material (2a), called "polymer front layer (2a)", and
- at least one front assembly (2b, 2c; 2d, 2e) comprising an interface front layer (2b; 2d) and a glass front layer (2c; 2e), the glass front layer (2c; 2e) with a thickness (e_{2c}; e₂ₑ) less than or equal to 2 mm,
said at least one front assembly (2b, 2c; 2d, 2e) being located between the polymer front layer (2a) and the encapsulating assembly (3), and the interface front layer (2b; 2d) of said at least one front assembly (2b, 2c; 2d, 2e) being located between the polymer front layer (2a) and the glass front layer (2c; 2e),
the method including the step of hot and vacuum lamination of the constituent layers of the stack to obtain the photovoltaic module (1),
**characterized in that** the front layer of an encapsulating material (3a) is formed by at least one layer comprising at least one polymer-type encapsulating material having a Young's modulus at 25°C comprised between 2 and 20 MPa,
and **in that** the rear layer of an encapsulating material (3b) is formed by at least one layer including at least one polymer-type encapsulating material having a Young's modulus at 25°C of strictly greater than 200 MPa.
